Europäisches Patentamt

European Patent Office

Office européen des brevets

(19)

(11) Publication number: **0 073 623**
**B1**

(12) **EUROPEAN PATENT SPECIFICATION**

(45) Date of publication of patent specification: **11.03.87**

(21) Application number: **82304433.4**

(22) Date of filing: **23.08.82**

(51) Int. Cl.⁴: **H 01 L 29/08,** H 01 L 29/10,
H 01 L 29/78

(54) Insulated gate field effect transistor.

(30) Priority: **24.08.81 JP 131521/81**

(43) Date of publication of application:
**09.03.83 Bulletin 83/10**

(45) Publication of the grant of the patent:
**11.03.87 Bulletin 87/11**

(84) Designated Contracting States:
**DE GB NL**

(56) References cited:
**DE-A-2 626 362**
**DE-A-2 911 726**
**FR-A-2 337 428**
**US-A-4 017 888**

**IEEE TRANSACTIONS ON ELECTRON
DEVICES, vol. ED-24, no. 3, March 1977, pages
196-204, New York, USA P. P. WANG: "Double
boron implant short-channel MOSFET"**

**SOLID-STATE ELECTRONICS, vol. 22, no. 3,
March 1979, pages 225-228, Pergamon Press,
Oxford, G.B. W. FISCHER et al: "Electron
mobility in Si-MOSFETs with an additional
implanted channel"**

(73) Proprietor: **Hitachi, Ltd.**
**5-1, Marunouchi 1-chome**
**Chiyoda-ku Tokyo 100 (JP)**

(72) Inventor: **Sunami, Hideo**
**2196-421, Hirai Hinodemachi**
**Nishitama-gun Tokyo (JP)**
Inventor: **Masuda, Hiroo**
**1473-B6-7, Josuihoncho**
**Kodaira-shi Tokyo (JP)**
Inventor: **Shimohigashi, Katsuhiro**
**3-124-10, Dainan Musashimurayama-shi**
**Tokyo (JP)**
Inventor: **Kamigaki, Yoshiaki**
**2-16-16, Nerima Nerima-ku**
**Tokyo (JP)**
Inventor: **Takeda, Eiji**
**5-36-8, Honcho Koganei-shi**
**Tokyo (JP)**

(74) Representative: **Calderbank, Thomas Roger
et al**
**MEWBURN ELLIS & CO. 2/3 Cursitor Street**
**London EC4A 1BQ (GB)**

## Description

The present invention relates to an insulated gate field effect transistor.

In a standard insulated gate field effect transistor particularly a MOS transistor, it is a current practice to form an impurity layer of the same conductivity type as that of the substrate of the transistor by implanting ions into a surface region of a channel of the transistor so as to raise the threshold voltage $V_{th}$ thereby to provide an enhancement type device. A MOS transistor of this type (which is called the "surface type") has a defect in that the so-called "short-channel effect" is high, e.g., the threshold voltage $V_{th}$ varies greatly with the gate length and also that the source-to-drain breakdown voltage is low.

To overcome this defect, it is known from e.g. an article by R. H. Dennard et al in IEEE Journal of Solid-State Circuits Vol SC9, No. 5 Oct. 1974 to form an impurity layer adjacent the surface of the channel which has a high impurity distribution close to the surface of the channel. This impurity layer is known as a "punch-through stopper". If a surface type MOS transistor has an impurity layer near the surface of the channel, then a depletion layer is formed in a region deeper within the channel than the impurity layer. Furthermore, the application of a voltage $V_D$ to the drain causes a depletion layer to extend from the drain, and this depletion layer may extend into the depletion layer in the channel and hence reach the source.

As a result, the short-channel effect is reduced but there is the disadvantage that the breakdown voltage of the drain junction is lowered, as is the source-to-drain breakdown voltage, because the impurity density in the vicinity of the drain is increased. Moreover, control of the threshold voltage $V_{th}$ of a transistor having a punch-through stopper is difficult.

One further disadvantage of any transistor having a channel with a construction as described is that the carrier mobility is low because carriers are allowed to move only within a limited region adjacent the surface of the channel portion.

DE—A—2 626 362 discloses an insulated gate field effect transistor having a construction as described above, in which the channel has an impurity of a conductivity type different from the surface of the substrate adjacent the surface of the channel, and an impurity of the same conductivity type as the substrate deeper within the channel. Thus this document corresponds to the pre-characterising part of claim 1.

However, this is not sufficient to cause satisfactory reduction in the short-channel effect, without a reduction in breakdown voltage. The present invention seeks to overcome this problem by providing an insulated gate field effect transistor in which the source and/or drain region has an impurity layer of the conductivity type different from the surface of the substrate adjacent the surface of the channel, the impurity layer having an impurity distribution which has a gradient which is gently sloped from a higher value inside the impurity layer to a lower value at an edge thereo. In this way the controllability of the threshold voltage is increased, and the source-to-drain breakdown voltage is improved, so that the transistor may be used in a LSI having a high density of integration.

Due to the punch-through stopper formed by the impurity distribution of the same conductivity type as that of the substrate, the short channel effect is reduced and an impurity of the conductivity type opposite to that of the substrate is introduced into the vicinity of the surface so that carriers forming a current injected from the source are made to flow closer to the substrate than is the case in the surface type transistor thereby achieving an improvement in the carrier mobility and the degree of control of the threshold voltage $V_{th}$ that can be achieved.

In order to prevent a reduction in the breakdown voltage of the drain junction due to the formation of the punch-through stopper, on the other hand, the gradient of the impurity density in the vicinity of the drain is so gently sloped as to make the electric field at the drain end gentle.

Embodiments of the invention will now be described by way of example, with reference to the accompanying drawings, in which:

Fig. 1 is a view showing an insulated gate field effect transistor according to a first embodiment of the present invention;

Figs. 2 to 4 are graphs illustrating impurity density distributions in the embodiment shown in Fig. 1;

Fig. 5 is a graph illustrating a portion of the characteristics of the embodiment of Fig. 1; and

Fig. 6 is a view showing an insulated gate field effect transistor according to a second embodiment of the present invention.

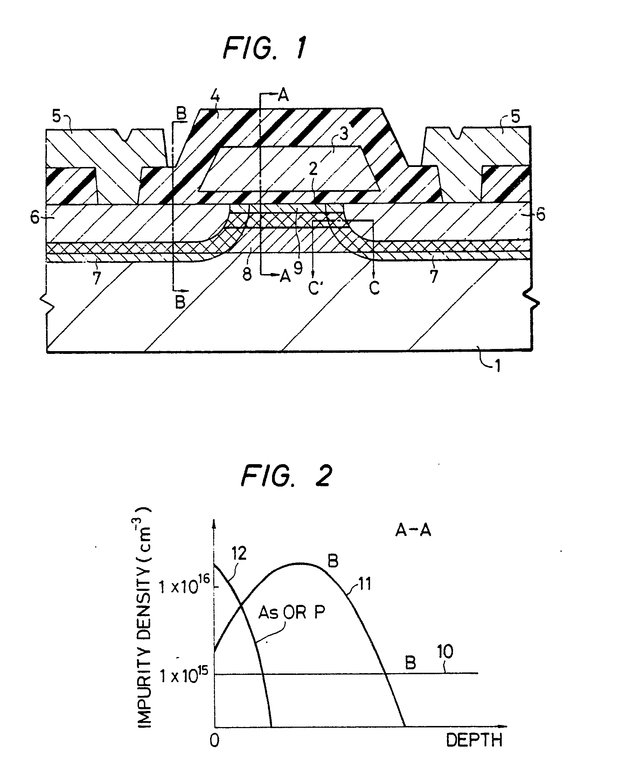

Referring to Fig. 1, the first embodiment of the present invention will now be described with reference to an n-channel MOS transistor.

A silicon (Si) substrate 1 is prepared to have a resistivity of about 10 $\Omega$ cm by adding boron (B) to a density of $1 \times 10^{15}$ cm$^{-3}$. The Si substrate 1 thus prepared is oxidized with dry oxygen to form a gate oxide film 2 having a thickness of 5 to 100 nm. After this, boron (B) is introduced, by e.g. ion-implantation at an energy of 50 to 300 keV, so that a peak is established in the substrate 1, as shown in Fig. 2 (which is a section taken along line A—A of Fig. 1). The boron distribution assumes the shape indicated at 11 in Fig. 2. The depth of the peak is about 0.4 µm at an energy of 150 keV. Since, in this case, the impurity density distribution 10 of the substrate is $1 \times 10^{15}$ cm$^{-3}$, the peak becomes effective if the peak density 11 of the boron (B), implanted to form a p-type layer 8, substantially exceeds $2 \times 10^{15}$ cm$^{-3}$. Thus, the dose is usually equal to or higher than $1 \times 10^{11}$ cm$^{-2}$. These deeply implanted boron atoms form a punch through stopper.

In order to form an n-type layer 9 having a conductivity type opposite to that of the substrate, an impurity represented by arsenic (As) or phosphorous (P) is then ion-implanted to have a

distribution indicated by curve 12 in Fig. 2. The implantation energy is usually about 30 to 100 keV, there being some variation on this to allow for the thickness of the gate oxide film 2 or the type of ions being implanted. The dose is chosen so that a desired threshold voltage $V_{th}$ is obtained, taking into account the dose of boron which was previously implanted. The dose of arsenic or phosphorous may be about $1 \times 10^{11}$ cm$^{-2}$ although it cannot be determined in isolation. This description assumes that the boron (B) is ion-implanted prior to the arsenic (As) or phosphorous (P), but it may be implanted afterwards, if desired.

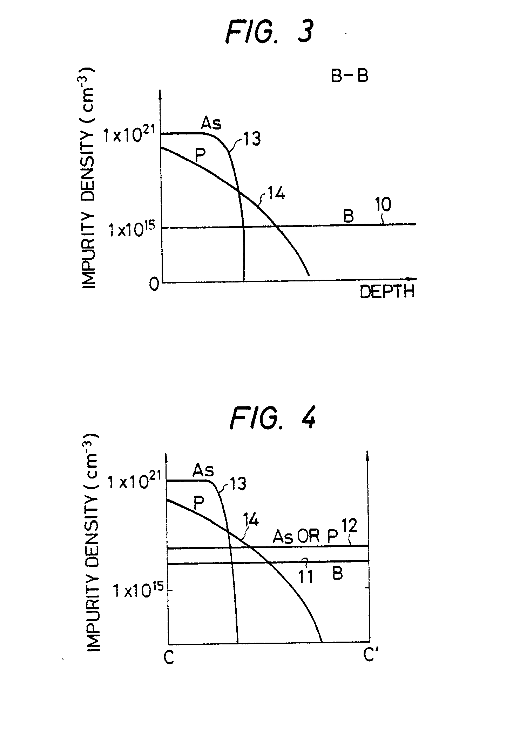

After that, a gate 3 made of a substance such as polycrystalline silicon, molybdenum or tungsten is selected for the purpose of covering, and arsenic (As) is ion-implanted all over the surface. The dose is about $1 \times 10^{16}$ cm$^{-2}$. Arsenic (As) is preferable because it can form an n$^+$-type layer 6 having a shallow junction and a low resistance, although it has a steep distribution as is indicated by curve 13 in Fig. 3 (which is a section taken along line B—B of Fig. 1) so that it has a lower source-to-drain breakdown voltage than that of the phosphorous (P). In order to offset the reduction in the breakdown voltage due to the steep distribution, however, according to the present invention, phosphorous (P) is further implanted at a dose of $1 \times 10^{15}$ to $5 \times 10^{16}$ cm$^{-2}$ thereby to form a P-diffusion layer 7, which has a distribution as is indicated by curve 14 in Fig. 3. Since phosphorous (P) has a faster diffusion rate than arsenic (As), the distribution 14 of phosphorous can be made to extend beyond the leading end of the arsenic (As) distribution 13 by heat treatment at 1000°C for about 30 minutes so that the excess portion is gently sloped as is illustrated in Figs. 3 and 4. The resultant gently sloped portion damps the intensity of the electric field, thereby to improve the source-to-drain breakdown voltage. Fig. 4 is a section taken along line C—C of Fig. 1.

In order to achieve a gentle slope (low overall gradient), it is sufficient if all the portions of the source and drain 6 and 7 are made of phosphorous (P). If, in this case, the depth Xj of the source-drain junction is 0.3 µm, the sheet resistance ρs can be as high as 100 Ω/□. If the junction having a thickness of Xj=0.3 µm is made of arsenic (As), however, the sheet resistance ρs is reduced to 2.5 Ω/□ so that the effect resulting from the use of arsenic (As) is remarkably high. Thus, there is a tendency that the sheet resistance ρs increases at lower depths Xj.

After that, an insulating film 4 which is made by the CVD method, of a material such as phosphosilicate glass (PSG) is selected for covering the device and a connecting electrode 5 of aluminium (Al) for the source-drain 6 is formed thus completing the desired MOS transistor.

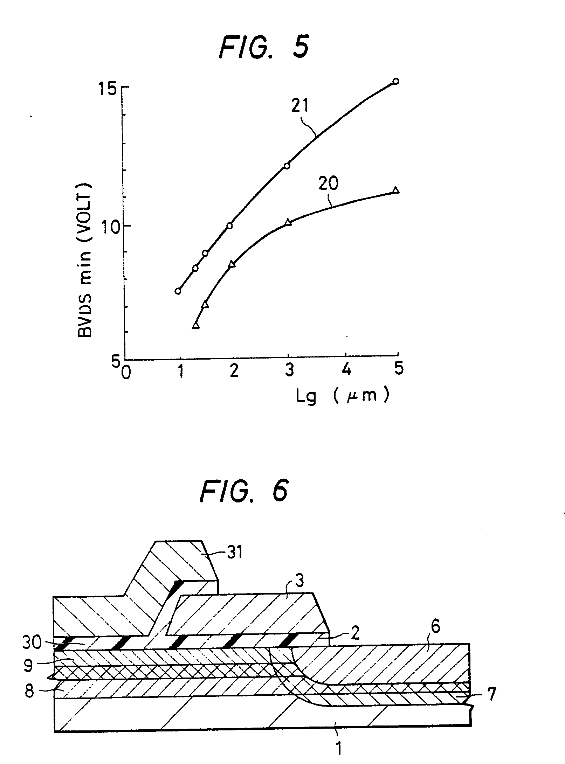

In the embodiment of the present invention thus described, the characteristics of the minimum-source-to-drain breakdown voltage $BV_{DS}$ min for a given gate length Lg are as is plotted in Fig. 5. It is assumed that the thickness of the oxide film is 35 nm and Xj=0.3 µm. Curve 20 plots the characteristics of a conventional surface type MOS transistor for reference, whereas curve 21 plots the characteristics of the MOS transistor according to the first embodiment of the present invention.

As is apparent from Fig. 5, the first embodiment has a much better source-to-drain breakdown voltage than the conventional surface type MOS transistor so that it can easily be used in the construction of a small-sized short-channel MOS transistor.

Fig. 6 is a sectional view showing a second embodiment of the present invention. In this embodiment, the impurity diffusion layer forming the source region is omitted, and a second gate 31 is provided in place thereof to overlie the substrate through a second gate insulating film 30.

The formation of the drain and the introduction of the impurity into the channel are the same as those of the first embodiment of Fig. 1. Therefore, boron (B) is ion-implanted into the channel region so that its peak falls at a portion having a depth of about 0.4 µm, thus forming the p-type layer 8. Moreover, arsenic (As) or phosphorous (P) is implanted into the portion closer to the surface, thus forming the n-type layer 9. On the other hand, the drain 6 is formed by double diffusions of arsenic (As) and phosphorous (P). This embodiment is a MOS transistor in which the surface region of the silicon (Si) substrate facing the second gate is used as the gate of the transistor. The impurity density of the region providing the source is not different from that of the channel region. This embodiment can also be said to provide an excellent structure for reduction of the short-channel effect and in the improvement in the source-to-drain breakdown voltage as in the first embodiment of Fig. 1.

As has been described according to the present invention, the source-to-drain breakdown voltage can be raised without deteriorating the short-channel effect. This also leads to the reduction in the channel hot electrons and to the improvement in the DC stress breakdown voltage. In other words, a shorter channel can be made possible, for an identical source-to-drain breakdown voltage thereby to enhance remarkably the performance of the transistor.

On the other hand, the impurity implanted into the surface and having a conductivity type opposite to that of the substrate serves to damp the electric field in the depth direction of the channel (i.e. in the direction toward the inside of the substrate) thereby to improve the effective carrier mobility. This improvement is found to be about 30% in the two embodiments described. This also enhances the capacity of the transistor and is advantageous for higher performance together with the improvement in the source-to-drain breakdown voltage.

Although the present invention has been described with reference to an N-channel type MOS transistor, the present invention can be achieved in an identical way in a P-channel type transistor if the impurity is of the opposite conductivity type. In this modification however, since the P-channel transistor uses an impurity such as boron (B), Ga or Aluminium (Al) in the source and drain, the slopes are substantially gentle, because the impurity has a fast diffusion rate, thus making it unnecessary to add different kinds of impurities to the source and drain regions, as had to be done in the embodiment of Fig. 1.

**Claims**

1. An insulated gate field effect transistor having a substrate (1) of a first conductivity type, a channel in a surface of the substrate (1), source and drain regions (6, 7) adjacent the channel, a gate electrode (3) overlying the channel and an insulating film (2) between the gate electrode (3) and the substrate (1), the channel having a first impurity (9) of the second conductivity type adjacent the surface of the substrate, and a second impurity (8) of the first conductivity type deeper within the channel than the first impurity (9): characterised in that: the source and/or drain region (6, 7) of a second conductivity type has an impurity distribution (13, 14) which is gently sloped from a higher value inside the region to a lower value at an edge thereof.

2. An insulated gate field effect transistor according to claim 1, wherein said second impurity (8) in the channel has a distribution (11) with a peak located within said substrate (1).

3. An insulated gate field effect transistor according to claim 1, or claim 2, wherein said second impurity (8) in the channel has a distribution (11) which extends at least as deep into the substrate as the impurity layer in the source and/or drain region (6, 7).

4. An insulated gate field effect transistor according to any one of the preceding claims, wherein the source and/or drain region includes a first impurity layer (6) having a high peak density and a steep distribution (13), and a second impurity layer (7) having a lower peak density than that of said first impurity layer (6) and a distribution (14) extending deeper into the substrate than said first impurity layer.

5. An insulated gate field effect transistor according to claim 4, wherein the first impurity layer (6) is formed by the diffusion of arsenic whereas said second impurity layer (7) is formed by the diffusion of phosphorous.

6. An insulated gate field effect transistor according to claim 1, wherein the drain region (6, 7) has an impurity layer of the second conductivity type having impurity distribution (13, 14) with a low overall gradient, the insulated gate field effect transistor further comprising a second gate electrode (31) formed to correspond to said source region; and a second gate insulating film (30) lying between said second gate electrode (31) and said source region.

7. An insulated gate field effect transistor according to claim 6, wherein said source region has the same impurity distribution as that of the channel.

**Patentansprüche**

1. Feldeffekttransistor mit isoliertem Gate mit einem Substrat eines ersten Leitungstyps, einem Kanal an der Oberfläche des Substrates (1), Source- und Draingebieten (6, 7), die dem Kanal benachbart sind, einer Gate-Elektrode (3), die über dem Kanal liegt, und mit einem Isolationsfilm (2) zwischen der Gate-Elektrode (3) und dem Substrat (1), wobei der Kanal angrenzend an die Oberfläche des Substrates ersten Dotierstoff (9) des zweiten Leitungstyps aufweist und wobei ein zweiter Dotierstoff (8) des ersten Leitungstyps im Kanal tiefer als der erste Dotierstoff (9) vorhanden ist, dadurch gekennzeichnet, daß das Source- und/oder Draingebiet (6, 7) des zweiten Leitungstyps eine Dotierstoffverteilung (13, 14) besitzt, die leicht von einem höheren Wert innerhalb des Gebietes zu einem niedrigeren Wert am Rande davon abfällt.

2. Feldeffekttransistor mit isoliertem Gate nach Anspruch 1, bei dem der zweite Dotierstoff (8) im Kanal eine Verteilung (11) mit einem im Substrat (1) gelegenen Peak besitzt.

3. Feldeffekttransistor mit isoliertem Gate nach Anspruch 1 oder 2, bei dem der zweite Dotierstoff (8) im Kanal eine Verteilung (11) besitzt, die sich wenigstens ebenso tief in das Substrat erstreckt wie die Dotierstoffschicht in dem Source- und/oder Draingebiet (6, 7).

4. Feldeffekttransistor mit isoliertem Gate nach einem der vorangehenden Ansprüche, bei dem das Source- und/oder das Draingebiet eine erste Dotierstoffschicht (6) mit einer hohen Peak-Dichte und einer steil abfallenden Verteilung (13) und eine zweite Dotierstoffschichtschicht (7) mit einer niedrigeren Peak-Dichte als jener der ersten Dotierstoffschicht (6) und einer Verteilung (14) enthält, welche sich tiefer in das Substrat erstreckt als die erste Dotierstoffschicht.

5. Feldeffekttransistor mit isoliertem Gate nach Anspruch 4, bei dem die erste Dotierstoffschicht (6) durch Diffusion von Arsen gebildet ist, während die zweite Dotierstoffschicht (7) durch Diffusion von Phosphor gebildet ist.

6. Feldeffekttransistor mit isoliertem Gate nach Anspruch 1, bei dem das Draingebiet (6, 7) eine Dotierstoffschicht des zweiten Leitungstyps mit einer Dotierstoffverteilung (13, 14) von niedrigem Gesamtgradienten aufweist und der Feldeffekttransistor mit isoliertem Gate weiter eine zweite Gate-Elektrode (31) besitzt, die so gebildet ist, daß sie dem Sourcegebiet entspricht, und daß ein zweiter Gate-Isolationsfilm (30) zwischen der zweiten Gate-Elektrode (31) und dem Sourcegebiet liegt.

7. Feldeffekttransistor mit isoliertem Gate nach Anspruch 6, bei dem das Sourcegebiet die gleiche Dotierstoffverteilung besitzt wie der Kanal.

## Revendications

1. Transistor à effet de champ à porte isolée ayant un substrat (1) d'un premier type de conductivité, un canal dans une surface du substrat (1), des régions de source et de drain (6, 7) adjacentes au canal, une électrode de porte (3) recouvrant le canal et un film isolant (2) entre l'électrode de porte (3) et le substrate (1), le canal ayant une première impureté (9) du second type de conductivité à proximité de la surface du substrat et une seconde impureté (8) du premier type de conductivité plus profondément dans le canal que la première impureté (9):
caractérisé en ce que:
la région de source et/ou de drain (6, 7) d'un second type de conductivité a une distribution d'impureté (13, 14) qui est légèrement en pente d'une valeur supérieure à l'intérieur de la région jusqu'à une valeur inférieure à un bord de celle-ci.

2. Transistor à effet de champ à porte isolée selon la revendication 1 où ladite seconde impureté (8) dans le canal a une distribution (11) avec une crête placée dans ledit substrat (1).

3. Transistor à effet de champ à porte isolée selon la revendication 1 ou la revendication 2 où ladite seconde impureté (8) dans le canal a une distribution (11) qui s'étend au moins aussi profondément dans le substrat que la couche d'impureté dans la région de source et/ou de drain (6, 7).

4. Transistor à effet de champ à porte isolée selon l'une quelconque des revendications précédentes où la région de source et/ou de drain contient une première couche d'impureté (6) ayant une densité de crête élevée et une distribution raide (13), et une seconde couche d'impureté (7) ayant une moindre densité de crête que celle de ladite première couche d'impureté (6) et une distribution (14) s'étendant plus profondément dans le substrat que ladite première couche d'impureté.

5. Transistor à effet de champ à porte isolée selon la revendication 4 où la première couche d'impureté (6) est formée par la diffusion d'arsenic tandis que ladite seconde couche d'impureté (7) est formée par la diffusion de phosphore.

6. Transistor à effet de champ à porte isolée selon la revendication 1 où la région de drain (6, 7) a une couche d'impureté du second type de conductivité ayant une distribution d'impureté (13, 14) avec un faible gradient total, le transistor à effet de champ à porte isolée comprenant de plus une seconde électrode de porte (31) formée pour correspondre à ladite région de source; et un second film isolant de porte (30) se trouvant entre ladite seconde électrode de porte (31) et ladite région de source.

7. Transistor à effet de champ à porte isolée selon la revendication 6 où ladite région de source a la même distribution d'impureté que celle du canal.

## FIG. 1

## FIG. 2

## FIG. 3

B-B

## FIG. 4

## FIG. 5

## FIG. 6